# EUROPEAN PATENT APPLICATION

(11) **EP 2 884 546 A1**
(43) Date of publication of application: **17.06.2015**
(21) Application number: 13197037.8
(22) Date of filing: 12.12.2013
(51) Int. Cl.: H01L 31/05, H01L 31/048

(54) **Solar cell module.**

(71) Applicant: Two.P.Management, 6220 Fleurus (BE); MNW Trade & Management, 6162 Bourglinster (LU)
(72) Inventor: Wiersma, Wopke, 6162 BOURGLINSTER (LU)
(74) Representative: Van Coppenolle, Frank

(57) **Abstract**

The present invention relates to a solar cell module with a substrate panel, a cover panel, and at least two solar cells assembled between the cover panel and the substrate panel. The solar cell module has electrically conductive areas on the back surface of the substrate panel to create connections between solar cells or other electronic components. The present invention further relates to a solar cell module comprising a frame manufactured by reaction injection molding and to a solar cell module optimised for heat transfer of electronic components used in the solar panel.

## Description

### Technical field

The present invention relates to a solar cell module and more particular to a solar cell module with photovoltaic cells and a frame manufactured by reaction injection molding.

### Background art

Interest in alternative energy has surged due to environmental issues and the depletion of fossil fuels. Among all technologies that are available on the market, the generation of electricity in solar cells through the photovoltaic effect take a central role in terms of research, investment and project development.

When being exposed to light, solar cells generate free charge carriers, that are subsequently collected. Strings of electrically connected solar cells are combined in a solar cell module. Typically, solar cells are embedded between two flat panels, at least one of which is transparent to light, and encapsulated using a laminating compound such as ethylene vinyl acetate. A junction box is attached to the unexposed side of the solar cell module assembling electric components such as bypass diodes and connecting DC wires. The solar cell panel further typically comprises a frame in order to avoid intrusion of moisture and to protect the solar cells against dirt.

The frame is typically made of aluminum. Such frames can however be subject to electrochemical corrosion, causing hotspot formation and a power drop of the module. A second type of known frames, such as for example disclosed in BE1018016, is a polyurethane (PU) frame. A PU frame, applied by reaction injection molding (RIM), eliminates corrosion risk as well as a possible cause for potential induced degradation (PID).

Systems known in the art have however still several disadvantages. The use of a junction box attached to the unexposed side of the solar cell module reduces the possibility of being applied in so-called building-integrated photovoltaic systems (BIPV) because the junction box adds a lot of thickness to the overall thickness of a solar cell module. Especially in BIPV systems, strict rules with respect to the overall thickness have to be respected and cannot be reached.

The structure and design of the solar cell modules do not allow much flexibility nor optional components. For example, AC output solar cell modules are known and DC output solar cell modules are known, but there is no flexibility to change from the one to the other. Production costs remain high because automation is difficult due to the structure of the known solar cell modules.

### Disclosure of the invention

It is an aim of the present invention to provide an improved solar cell module which is more flexible in use and is the product of a highly-automated manufacturing process at a reduced cost.

This aim is achieved according to the invention with a solar cell module incorporating a substrate panel with a first inner surface and a back surface, a cover panel with a front surface and a second inner surface, and at least two solar cells assembled between the first and second inner surface showing the technical characteristics of the first independent claim. The solar cell module comprises a first electrically conductive area on the back surface of the substrate panel and the first electrically conductive area electrically connects the at least two solar cells.

By positioning the electrical connection between the solar cells on the back surface of the substrate panel, this electrically conductive area can be provided on the substrate panel as a preparation step and/or pre-production product prior to manufacturing. This allows a higher degree of automation in production. It also allows the panels to become more compact in length and thickness which decreases consumption of raw materials. Both advantages result in cost reductions.

In a preferred embodiment, the solar cell module further comprises a second electrically conductive area on the back surface of the substrate panel and not in contact with the first electrically conductive area, a third electrically conductive area on the back surface of the substrate panel and not in contact with the first and second electrically conductive area, and a first and a second contact for connecting the solar cell module in a circuit of multiple solar cell modules. The first solar cell of the at least two solar cells in the solar cell module is electrically connected with the first contact by the second electrically conductive area and the last solar cell of the at least two solar cells is electrically connected with the second contact via the third electrically conductive area.

Providing more conductive areas on the back surface of the substrate panel has the advantage that this can also be executed in a pre-manufacturing step such that the automated manufacturing process is more effective resulting in a lower manufacturing cost. Further the first and second contacts allow the solar cell module to be assembled into a direct current (DC) circuit of multiple solar cell modules.

In a further preferred embodiment of the invention, the solar cell module comprises an inverter having a first DC inverter contact and a second DC inverter contact and two AC inverter contacts for assembling the solar cell module in a circuit of multiple solar cell modules, a fourth electrically conductive area on the back surface of the substrate panel not in contact with the first electrically conductive area, and a fifth electrically conductive area on the back surface of the substrate panel not in contact with the first and fourth electrically conductive area. The first DC inverter contact is electrically connected with the first of said at least two solar cells by said fourth electrically conductive area and said second DC inverter contact is electrically connected with the last of said at least two solar cells by said fifth electrically conductive area.

By providing conductive areas on the back surface of the substrate panel ready for connection with an inverter, the manufacturing process is again facilitated resulting in a lower manufacturing cost. The use of an inverter allows the direct current (DC) to be transformed into alternating current (AC) at the solar cell module such that the solar cell module can be assembled in an AC circuit of solar cell modules.

In a further preferred embodiment, a solar cell module comprises a second electrically conductive area on the back surface not in contact with the first electrically conductive area, a third electrically conductive area on the back surface not in contact with the first and second electrically conductive areas, a fourth electrically conductive area on the back surface not in contact with the first, second and third conductive areas, and a fifth electrically conductive area on the back surface not in contact with the first, second, third and fourth electrically conductive areas, wherein said second electrically conductive area is electrically connected to the first of the at least two solar cells and is configured to be soldered to the first contact, wherein the third electrically conductive area is electrically connected to the last of the at least two solar cells and is configured to be soldered to the second contact, wherein the fourth electrically conductive area is electrically connected to the first of the at least two solar cells and is configured to be soldered to a first DC inverter contact, and wherein the fifth electrically conductive area is electrically connected to the last of the at least two solar cells and is configured to be soldered to a second DC inverter contact.

By providing conductive areas on the back surface of the substrate panel in pre-production configured such that or the first and second contact or inverter contacts can be soldered to the back surface of the substrate panel, the resulting solar cell module can be easily manufactured in an automated way as a DC solar cell module or an AC solar cell module. Furthermore, the decision to manufacture in the manufacturing process a DC or AC solar cell module can be made during the manufacturing process and late in the manufacturing process. Further, once a solar cell module is installed or has to be installed, it is still easy for an installer to change a DC solar cell module in an AC solar cell module or vice versa because the needed electrically conductive areas for both are available on the back surface of the substrate panel. Therefore, the provided electrically conductive areas result in an enormous flexibility.

In still a further embodiment, the solar cell module comprises at least three rows or arrays of at least two solar cells assembled between the first and second inner surface and a sixth electrically conductive area on the back surface of the substrate panel, wherein the sixth electrically conductive area electrically connects at least two solar cells at an end of the substrate panel opposite to the end where the first electrically conductive area is electrically connecting two solar cells.

This solar cell module is further increasing the amount of structure which can be executed in pre-production resulting in a higher degree of automation during manufacturing of the solar cell module itself. It's also advantageous for the compactness of the solar cell module.

In one embodiment, the electrically conductive areas of the solar cell module mentioned above comprise a metal.

In a further embodiment, the electrically conductive areas of the solar cell module mentioned above comprise silver.

The use of silver or a conducting metal as in previous embodiment, reduces the electrical resistance of the conductive areas, minimizing power losses.

In one embodiment, the solar cell module comprises a PU frame, covering at least one of the electrically conductive areas mentioned above. This results in an effective sealing of the electrical parts of the solar cell module from external influences.

In another embodiment, the solar cell module comprises further electrically conductive areas on the back surface of the substrate panel, wherein the further electrically conductive areas are configured to solder electronic components to the further electrically conductive areas.

This has the advantage that a solar cell module can have several optional electronic components and that in the automatic manufacturing process the same substrate panel can be used to produce solar cell modules containing a selection of these optional electronic components. It also offers flexibility to add an electronic component after manufacturing or to manufacture different types of solar cell modules in the same manufacturing line only by selecting which electronic components are included and which not.

In a further embodiment, the solar cell module comprises electronic components, which are embedded in the PU frame.

By embedding these components in the frame, they are covered from external influences and the risk for power losses is minimized.

In a further embodiment, the electronic components are positioned behind the inner surface of the cover panel such that heat generated by the electronic components is transferred through the cover panel.

When the heat generated by the electronic components embedded in the frame is transferred to the inner surface of the cover panel, there is no diffusive flux of heat in the frame which could cause damage to any structure underlying the solar cell module. Furthermore, when heat is not transferred efficiently from the electronic components, the heat can damage them. This is especially the case for electronic components which are producing relatively a large amount of heat such as bypass diodes.

In one embodiment, the electronic components embedded in the frame are bypass diodes.

In an embodiment with both, the bypass diodes embedded in the frame and with first and second contacts for a DC solar cell module or with an inverter soldered to an electrically conductive area on the back surface of the substrate panel, there is no longer a need for a junction box. This reduces the thickness of the solar cell module which is advantageous in many assembly structures.

In still a further embodiment, the solar cell module comprises means for accelerating heat transfer from the electronic components to the cover panel.

In another embodiment, the substrate panel comprises a first, a second, a third and a fourth substrate side surface, the cover panel comprises a first, a second, a third and a fourth cover side surface, the substrate panel is in at least one direction, width or height, shorter than the cover panel, and at least one of said substrate side surfaces of said substrate panel is at a distance from said corresponding side surface of said cover panel.

In another embodiment, the solar cell module comprises a substrate panel with an inner surface, a back surface and first, second, third and fourth substrate side surfaces, a cover panel with a front surface and a second inner surface, and first, second, third and fourth cover side surfaces, and at least two solar cells assembled between said first and second inner surface. The substrate panel is in at least one direction, width or height, shorter than the cover panel, and at least one of said substrate side surfaces of said substrate panel is at a distance from said corresponding side surface of said cover panel.

This allows an easy electrical connection between the solar cells of the solar cell module positioned between the second inner surface of the cover panel and the first inner surface of the substrate panel and the electrically conductive areas on the back surface of the substrate panel. This also facilitates embedding of electronic components such as bypass diodes in a frame and this structure allows heat transfer of electronic components positioned behind the cover panel and on the side of the substrate panel towards the cover panel.

### Brief description of the drawings

The invention will be further elucidated by means of the following description and the appended figures.
Figure 1a shows a front view of a partly assembled solar cell module in accordance with a preferred embodiment of the present invention.
Figure 1b shows a rear view of the partly assembled solar cell module illustrated in Figure 1a.
Figure 1c shows a schematic representation of the side view of the partly assembled solar cell module illustrated in Figure 1 a wherein the hidden solar cells are represented in full lines for clarity.
Figure 1d also shows a schematic representation of the solar cell module illustrated in Figure 1 a in a further step of the manufacturing process. The hidden solar cells are represented in full lines and only part of the frame 60 is shown for reasons of clarity.
Figure 2a shows a front view of a solar cell module in accordance with another preferred embodiment of the present invention.
Figure 2b shows a rear view of the solar cell module illustrated in Figure 2a.
Figure 2c shows a schematic representation of a side view of the solar cell module illustrated in Figure 2a. Hidden components are represented in full lines.
Figure 2d also shows a schematic representation of the the solar cell module illustrated in Figure 2a in a further step of the manufacturing process. Hidden components are represented in full lines and only part of the frame 60 is shown for reasons of clarity.
Figure 3a shows a front view of a solar cell module in accordance with another preferred embodiment of the present invention.
Figure 3b shows a rear view of the solar cell module illustrated in Figure 3a.
Figure 3c shows a schematic representation of a side view of the solar cell module illustrated in Figure 3a. Hidden components are represented in full lines.
Figure 3d also shows a schematic representation of the side view of the solar cell module illustrated in Figure 3a in a further step of the manufacturing process. Hidden components are represented in full lines and only part of the frame 60 is shown for reasons of clarity.
Figure 4a shows a front view of a solar cell module in accordance with another preferred embodiment of the present invention.
Figure 4b shows a rear view of the solar cell module illustrated in Figure 4a.
Figure 4c shows a schematic representation of the side view of the solar cell module illustrated in Figure 4a. Hidden components are represented in full lines.
Figure 4d also shows a schematic representation of the side view of the solar cell module illustrated in Figure 4a in a further step of the manufacturing process. Hidden components are represented in full lines and only part of the frame 60 is shown for reasons of clarity.
Figure 5a shows a front view of a solar cell module in accordance with another preferred embodiment of the present invention.
Figure 5b shows a rear view of the solar cell module illustrated in Figure 5a.
Figure 5c shows a schematic representation of the side view of the solar cell module illustrated in Figure 5a. Hidden components are represented in full lines.
Figure 5d also shows a schematic representation of the side view of the solar cell module illustrated in Figure 5a in a further step of the manufacturing process. Hidden components are represented in full lines and only part of the frame 60 is shown for reasons of clarity.
Figure 6 shows a perspective view of a representation of the cover panel and the substrate panel of the solar cell module.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

Furthermore, the various embodiments, although referred to as "preferred" are to be construed as exemplary manners in which the invention may be implemented rather than as limiting the scope of the invention.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present invention, the only enumerated components of the device are A and B, and further the claim should be interpreted as including equivalents of those components.

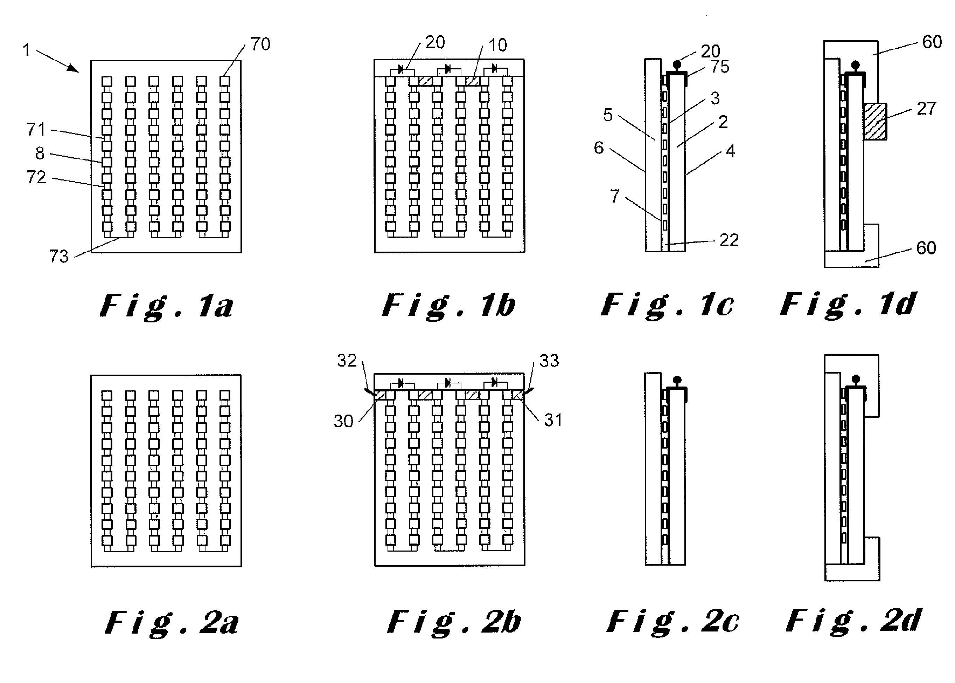

Referring to Figure 1a, Figure 1b, Figure 1c and Figure 1d, Figure 1 a represents a front view and Figure 1b a rear view of a partly assembled solar cell module 1 in accordance with a preferred embodiment of the present invention. Figures 1c and 1d show a schematic representation of a side view of Figure 1b wherein Figure 1d is the corresponding side view at a later phase of the manufacturing (assembling) process. Both drawings are represented as wireframes, i.e. with hidden components represented in full lines. The two side views are added with the aim of clarifying the different phases of production of the present invention, with Figure 1d being the end product including the frame 60. For the sake of clarity, only the top part and bottom part of the frame 60 are represented in Figure 1 d.

The solar cell module 1 as shown in Figure 1a to 1d comprises a substrate panel 2 with a first inner surface 3 and a back surface 4, and a cover panel 5 with a front surface 6 and a second inner surface 7. Six rows 70 of ten solar cells 8 each are assembled between the first inner surface 3 and the second inner surface 7. In an alternative embodiment there are at least two solar cells. In further alternative embodiments of the present invention, the solar cell module 1 may comprise a higher or lower number of rows 70 and solar cells 8 per row 70, as is known in the state of the art, with a total minimum of two solar cells 8.

The solar cells 8 are encapsulated between the first inner surface 3 and the second inner surface 7 by a laminating material 22. For encapsulating solar cells 8, ethyl vinyl acetate, silicones or other materials known in the state of the art can be used as laminating material 22.

The six rows 70 of solar cells 8 are assembled in series in a string 71. The solar cells in one row 70 are electrically connected through soldered tab wire 72 and the rows 70 are at one side of the panel electrically connected with soldered bus wire 73. For clarity of the figures, in the embodiment of Figures 1a to 1d, the soldered tab wire is shown in Figures 1 a and 1b only and omitted in Figures 1c and 1d. In alternative embodiments, alternative techniques known in the art are used in stead of tab wire 72. Further, as an alternative from being assembled in series, the solar cells 8 can also be electrically connected in parallel.

The embodiment illustrated in Figures 1a to 1d, further comprises a first electrically conductive area 10 on the back surface 4 of the substrate panel 2. The first electrically conductive area 10 electrically connects two solar cells 8 at the end of two different rows 70. The first electrically conductive area is located on the first inner surface 3 of the substrate panel 2 and the solar cells are located between the first inner surface 3 and the second inner surface 7. To make an electrical connection between the solar cells 8 and the first electrically conductive area 10 an extended end 75 of tab wire 72 is bended over the side surface of the substrate panel 2 towards the back surface 4 of the substrate panel. At that position the extended end 75 of the tab wire 72 is soldered to the first electrically conductive area 10. In the embodiment of the Figures 1 a to 1 d, the positioning of the first electrically conductive area 10 is near the side surface of the substrate panel 2 which is advantageous to cover it by a PU frame as will be discussed below. In alternative embodiments the first electrically conductive area 10 may be on whatever position on the back surface 4.

The above described method of connecting the solar cells 8 has several advantages. Firstly, the first electrically conductive area 10 is designed to have a low resistance, thus minimizing current losses. Secondly, a substrate panel 2 which is provided with a first electrically conductive area 10 prior to manufacturing, allows an easier production process and increases automation of manufacturing, as the use for soldered bus wire 73 is no longer necessary. Further, the electrical connection between two solar cells 8 of two different rows 70 is made at the back surface 4 of the substrate panel 2 and not alongside of the solar cells 8 on the first inner surface 3. This has the immediate effect that the solar cell module 1 can be decreased in size and thus becomes more compact. Compactness is an advantage as such and it also reduces the cost of the solar cell module.

In alternative embodiments, in stead of using an extended end 75 of the tab wire 72 for connecting the solar cells 8 and the first electrically conductive area 10 over the side surface of the substrate panel, a different method known in the art is used to electrically connect the solar cells 8 and the first electrically conductive area 10.

The first electrically conductive area 10 comprises materials with a high electrical conductance. In the embodiment of Figures 1a to 1d, the first electrically conductive area 10 is made of silver. In alternative embodiments the first electrically conductive area 10 may be copper or any other electrically conductive material. The first electrically conductive area 10 can be applied on the back surface 4 of the substrate panel 2 by screen printing, coating or any other technique known in the art useful for applying an electrically conductive material on a surface of a substrate panel such as gluing, wiring or plating. In a preferred embodiment of the present invention the first electrically conductive area 10 is screen-printed on the back surface 4 of the substrate panel 2 which is in a preferred embodiment of the invention a glass panel. First, the glass panel is printed at the location where the conductive area 10 has to be created. Subsequently, after the glass panel has been printed on the back surface, the ink is cured in a lehr or temper-surface at a temperature of +600° C which fuses the printed layer with the glass surface for permanent characteristics. In another preferred embodiment, the first electrically conductive area is coated on the substrate panel. A coating is in particular useful when the electrically conductive are is protected afterwards by a PU frame as will be discussed in more detail below.

The solar cell module 1 is encapsulated in a frame 60 using Reaction Injection Molding (RIM). A thermoset polymer is cured in a mold forming the frame 60 around the panels. The choice for a polymer frame has important advantages. The polymer frame 60 forms a better protection for the solar cell module 1 from moisture and other external effects. The frame 60 also covers and therefore completely protects the first electrically conductive area 10. Another advantage is a reduction of the risk for potential induced degradation (PID). PID occurs when ion mobility increases between the solar cells 8 and the other elements of the solar cell module 1 resulting in a decreased power output of the solar cell module 1. By using a polymer frame 60, the risk of PID is decreased. In the embodiment of the Figures 1a to 1d part of the electrical contacts, for instance the extended ends 75 of tab wire 72, are bended away from the cover panel 5 to the back surface 4 of the substrate panel 2. Depending on the choice of material for the substrate panel 2, the part comprising the first electrically conductive area 10 can subsequently be protected from PID.

Bypass diodes 20 are encapsulated in the frame 60. The bypass diodes 20 are generating heat. By the positioning of the bypass diodes as shown in Figure 1c, the heat is subsequently transferred to the cover panel 5. Further, as shown in Figure 1d, the bypass diodes 20 are encapsulated in the frame 60 and a large amount of the heat generated by the bypass diodes 20 reaches the cover panel 5 wherein it is further transferred to the front surface. In an alternative embodiment, the bypass diodes 20 are touching the second inner surface 7 of the cover panel 5. This allows a higher amount of heat transfer from the diodes 20 to the cover panel 5 and the heat transfer will also be accelerated. In still alternative embodiments, a heat sink or any other heat transfer improving material or object is positioned between the bypass diodes 20 and the inner surface 7 of the cover panel 5 to improve the heat transfer from the bypass diodes 20 to the cover panel 5. The resulting heat transfer will again be in a higher amount and faster.

Further in the embodiment of Figures 1a to 1d, a junction box 27 is attached to the back surface 4 of the substrate panel 2. The junction box is soldered to the conductive areas and provides connection to the connection wires of the solar panel. In this embodiment, the solar panel has a DC wiring. In an alternative embodiment, the bypass diodes 20 are not positioned in the frame but are part of the junction box 27.

Referring to Figure 2a, Figure 2b, Figure 2c and Figure 2d, Figure 2a represents a front view and Figure 2b a rear view of a solar cell module 1 in accordance with another preferred embodiment of the present invention. Similar to the previous embodiment, Figures 2c and 2d show a schematic representation of a side view of Figure 2b, with both drawings represented as wireframes and hidden components represented in full lines. Again, Figure 2d represents the end product including the frame 60. For the sake of clarity, only the top part and bottom part of the frame 60 are represented in Figure 2d.

A second electrically conductive area 30 and a third electrically conductive area 31 are fixed to the back surface 4 of the substrate panel 2. The solar cell module 1 comprises also a first contact 32 and a second contact 33 which can contact the solar cell module 1 into a direct current (DC) circuit. The second electrically conductive area 30 is electrically connected to the first contact 32 and the third electrically conductive area 31 is electrically connected to the second contact 33. This allows the first solar cell 8 of the string 71 to be connected to the first contact 32 by the second electrically conductive area 30 via the same methodology described above. Likewise, the last solar cell 8 of the string 71 can be connected to the second contact 33 by the third electrically conductive area 31. Both second and third electrically conductive areas 30,31 are also protected by the frame 60 as described for the embodiment above. The second and third electrically conductive areas 30,31 can be made from the same materials and are applied on the back surface 4 using the same methods as described above with respect to the first electrically conductive area 10.

Bypass diodes 20 are encapsulated in frame 60. This is advantageous because the junction box 27 typically assembles all wiring and electrical components, and, with the bypass diodes 20 encapsulated in the frame 60 and the first and second contacts 32, 33 allowing the solar cell module 1 to be used in a direct current circuit, there is no more need for a junction box 27. As a result, the overall thickness of the solar cell module 1 can be reduced which is advantageous for use of the solar cell module in building-integrated photovoltaic systems, where module thickness is very important.

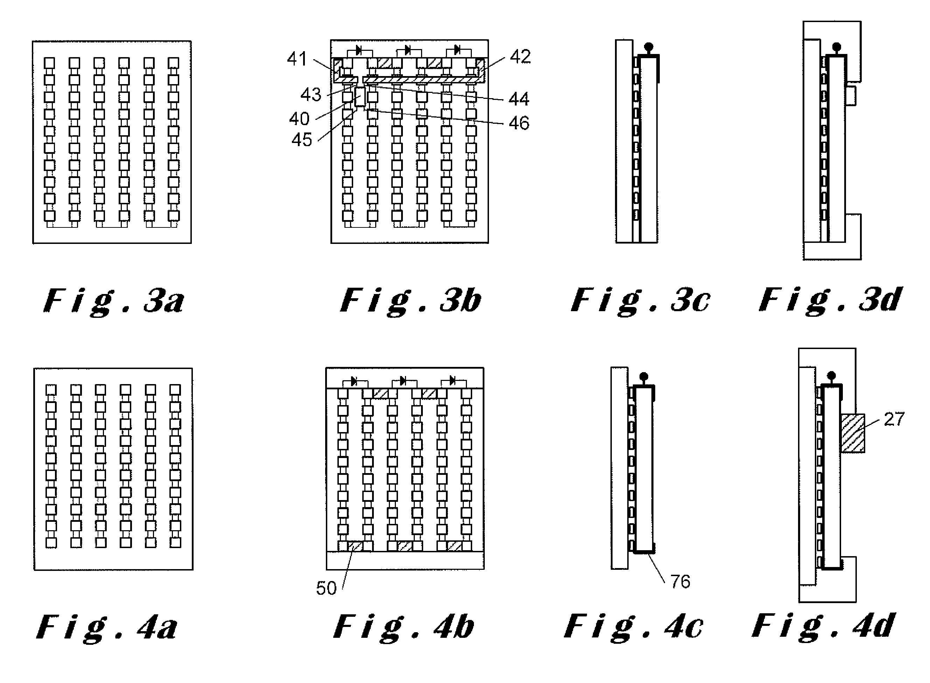

Referring now to Figure 3a, Figure 3b, Figure 3c and Figure 3d, Figure 3a represents a front view and Figure 3b represents a rear view of a solar cell module 1 in accordance with another preferred embodiment of the present invention. Similar to the previous embodiment, Figures 3c and 3d show a schematic representation of a side view of Figure 3b, with both drawings represented as wireframes and hidden components represented in full lines. Figure 3d represents the end product including the frame 60. For the sake of clarity, only the top part and bottom part of the frame 60 are represented in Figure 3d.

An inverter or DC optimizer 40 is encapsulated in the frame 60 of the solar cell module 1. An inverter is used in a solar cell module 1 to convert DC current from a string 71 or part of a string 71 to AC current. A DC optimizer is used in a solar cell module 1 to maximize the DC output. A fourth electrically conductive area 41 and a fifth electrically conductive area 42 are fixed to the back surface 4 of the substrate panel 2. A first DC inverter contact 43 is electrically connected to the fourth electrically conductive area 41 and a second DC inverter contact 44 is electrically connected to the fifth electrically conductive area 42. The inverter 40 also comprises two AC inverter contacts 45, 46 for assembling the solar cell module 1 in a circuit of multiple solar cell modules. The first of the solar cells 8 of the string 71 is electrically connected with the fourth electrically conductive area 41. The technical structure on how to electrically connect a solar cell to an electrically conductive area is the same as described above with respect to the embodiment of Figures 1a to 1d and comprises establishing an electrical connection by bending the extended end 75 of tab wire 72 from the first inner surface 3 to the back surface 4 and contacting the tab wire 72 with the fourth electrically conductive area 41. Likewise, the last of the solar cells 8 of the string 71 is electrically connected with the fifth electrically conductive area 42.

Similar to the inverter, a DC optimizer uses two DC optimizer contacts to electrically connect the fourth and fifth electrically conductive areas 41,42.

Consequently, the inverter or DC optimizer 40 is electrically connected with the first of the solar cells 8 of the string 71 via the fourth electrically conductive area 41. The inverter or DC optimizer 40 is equally connected with the last of the solar cells 8 of the string 71 via the fifth electrically conductive area 42. Both fourth and fifth electrically conductive areas 41,42 are protected by the frame 60. The fourth and fifth electrically conductive areas 41,42 can be made from the same materials and are fixed to the back surface 4 using the same methods as described above for the first electrically conductive area 10.

In another alternative embodiment, an encapsulated inverter 40 is combined with the use of first and second contacts 32,33. While the former inverts the generated direct current to alternating current, the latter allows the solar cell module 1 to be part of a direct current circuit. A combination of both components in one system has several advantages. As only a single product, equipped for all uses, is manufactured, production can be more automated. Secondly, due to its flexibility, the solar cell module is more adapted and ready-to-use for different markets. Alternatively, only the conductive areas for an inverter 40 and/or for the first and second contact 32, 33 are provided on the substrate panel creating the same advantages.

In alternative embodiments of the present invention, the inverter or DC optimizer is not encapsulated in the frame 60 but attached to the solar cell module 1 according to any other method known in the art.

Referring now to Figure 4a, Figure 4b, Figure 4c and Figure 4d, Figure 4a represents a front view and Figure 4b represents a rear view of a solar cell module 1 in accordance with another preferred embodiment of the present invention. Similar to the previous embodiment, Figures 4c and 4d show a schematic representation of a side view of Figure 4b, with both drawings represented as wireframes and hidden components represented in full lines. Figure 4d represents the end product including the frame 60. For the sake of clarity, only the top part and bottom part of the frame 60 are represented in Figure 4d.

A sixth electrically conductive area 50 is provided on the back surface 4 of the substrate panel 2, near the side surface opposite to the side surface where the first electrically conductive area 10 is provided. The sixth electrically conductive area 50 is also protected by the frame 60. The sixth electrically conductive area 50 and two solar cells 8 of two different rows 70 are positioned substantially at the same position on the substrate panel 2, but on opposite sides, being the back surface 4 and the first inner surface 3 respectively. An electrical connection is subsequently made between the two solar cells 8 of these two different rows 70 by bending the extended end 76 of tab wire 72 of both rows 70 from the first inner surface 3 to the back surface 4 and contacting both tab wires 72 with the sixth electrically conductive area 50.

In alternative embodiments the sixth electrically conductive area 50 may be on whatever position on the back surface 4.

The sixth electrically conductive area 50 can be made from the same materials and is fixed to the back surface 4 using the same methods as described above for the first electrically conductive area 10.

The advantages of this method are the same as the advantages described for the first electrically conductive area 10. The sixth electrically conductive area 50 is designed to have a low resistance, which minimizes current losses. The important advantage is the possibility to abandon the use of bus wire 73 altogether. When both a first electrically conductive area 10 and a sixth electrically conductive area 50 are combined in a solar cell module 1 for laterally connecting the rows 70 of solar cells 8, there is no more need for bus wire 73. Using substrate panels 2 provided with first and sixth electrically conductive areas 10,50 prior to manufacturing increases automation of production, reduces costs and facilitates production processes. Following the arguments described above, the solar cell module 1 becomes more compact, leading to further cost reduction.

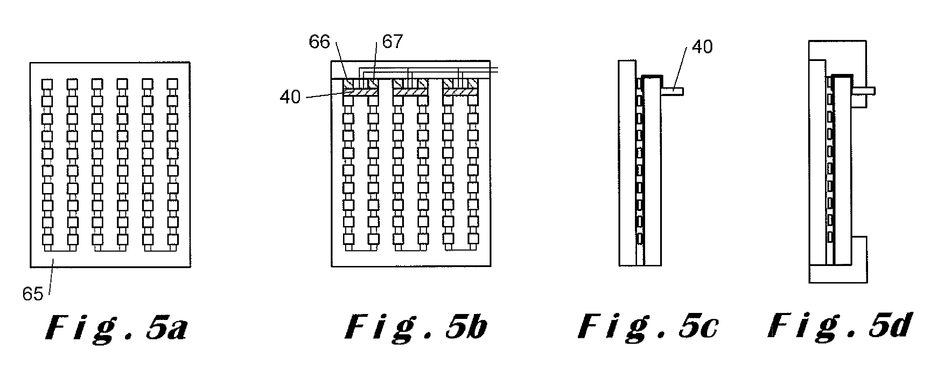

Referring now to Figure 5a, Figure 5b, Figure 5c and Figure 5d, Figure 5a represents a front view and Figure 5b represents a rear view of a solar cell module 1 in accordance with another preferred embodiment of the present invention. Similar to the previous embodiment, Figures 5c and 5d show a schematic representation of a side view of Figure 5b, with both drawings represented as wireframes and hidden components represented in full lines. Figure 5d represents the end product including the frame 60. For the sake of clarity, only the top part and bottom part of the frame 60 are represented in Figure 5d.

In the preferred embodiment of the present invention illustrated in Figures 5a to 5d, the solar cell module 1 has six adjacent rows 70 of ten solar cells 8 assembled in series. The six adjacent rows 70 form three sections 65 comprising two adjacent rows 70. For every section 65, a seventh electrically conductive area 66 and an eight electrically conductive area 67 are fixed to the back surface 4 of the substrate panel 2. The first solar cell 8 of a section 65 is electrically connected to the seventh electrically conductive area 66 assigned to this section 65 via the technology of bending an extended end of bus wire over the side surface as described above. Likewise, the last solar cell 8 of a section 65 is electrically connected to the eight electrically conductive area 67 assigned to this section 65. The seventh and eight electrically conductive areas 66,67 are covered by the frame 60.

For every section 65, an inverter 40 is encapsulated in the frame 60 of the solar cell module 1. In alternative embodiments of the present invention, the inverter 40 is not encapsulated in the frame 60 but attached to the solar cell module 1 according to any other method known in the art.

Each inverter 40 is electrically connected with the seventh and eight electrically conductive areas 66,67 of the same section 65. An inverter 40 is therefore electrically connected with the first solar cell 8 of the same section 65 via the seventh electrically conductive area 66, and it is electrically connected with the last solar cell 8 of the same section 65 via the eight electrically conductive area 67. This results in a structure as shown in Figure 5b wherein each row 70 is connected to one inverter 40. Likewise, solar cells 8 cannot be electrically connected to more than one inverter 40.

Inverters 40 are used in a solar cell module 1 to convert DC current to AC current. In the preferred embodiment of the present invention illustrated in Figures 5a to 5d, an inverter is used for every section 65. Consequently, there is no further need for a bypass diode 20. As the inverters are providing each an AC output, there is no longer a need for a junction box 27 either. As a result, as described above, the overall thickness of the solar cell module 1 is reduced. This an advantage when the solar cell module 1 is used in building-integrated photovoltaic systems (BIPV).

In another alternative embodiment, the use of an inverter 40 per section 65 is combined with the use of first and second contacts 32,33. The advantages were mentioned above. Production can be more automated, as only a single product needs to be manufactured. Secondly, due to its flexibility, the solar cell module 1 is more adapted and ready-to-use for different markets.

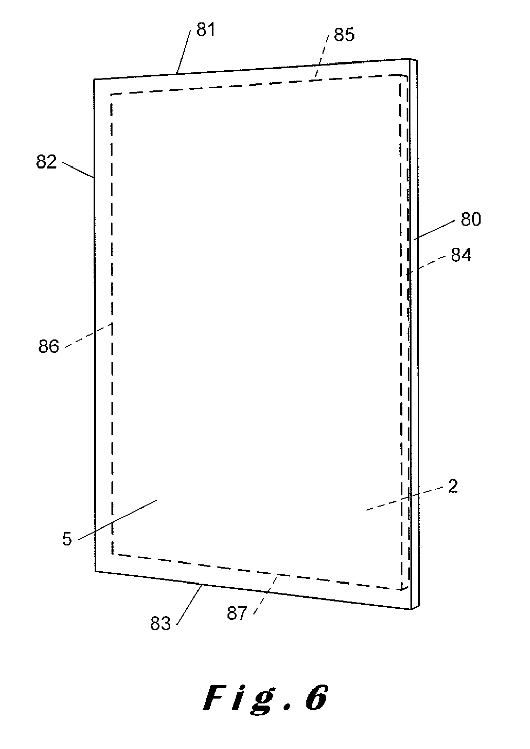

Referring now to Figure 6, a view in perspective of the cover panel 5 and the substrate panel 2 is shown. The cover panel 5 has a front surface 6 and a second inner surface 7, and first 80, second 81, third 82 and fourth 83 cover side surfaces. The substrate panel has a first inner surface 3, a back surface 4 and first 84, second 85, third 86 and fourth 87 substrate side surfaces. Each side surface of a panel can be ascribed to a corresponding side surface of the other panel.

In the preferred embodiment of the present invention illustrated in Figure 6, solar cells 8 are assembled between the first and second inner surface 3,7, according to the description above. The cover panel 5 completely covers the substrate panel 2, wherein at least one of the side surfaces of the substrate panel is at a distance from its corresponding side surface of the cover panel. This is the case when or the width or the length of the substrate panel is shorter than respectively the width or the length of the cover panel.

The advantage is manifold. It allows an easier electrical connection between the solar cells 8 situated between the first and second inner surfaces 3,7 and the electrically conductive areas 10, 30, 31, 41, 42, 50, 66, 67 described above. It also allows the encapsulation of electrical components such as bypass diodes in the frame 60. Another advantage is the saving in material due to a smaller substrate panel 2.

## Claims

1. A solar cell module (1), comprising
a substrate panel (2) with a first inner surface (3) and a back surface (4),
a cover panel (5) with a front surface (6) and a second inner surface (7), and
at least two solar cells (8) assembled between said first and second inner surfaces (3,7),
**characterized in that**,
said solar cell module (1) further comprising a first electrically conductive area (10) on the back surface (4) wherein said first electrically conductive area (10) electrically connects said at least two solar cells (8).

2. A solar cell module (1) according to claim 1, further comprising
a second electrically conductive area (30) on the back surface (4) not in contact with said first electrically conductive area (10),
a third electrically conductive area (31) on the back surface (4) not in contact with said first and second electrically conductive areas (10, 30),
a first contact (32) for connecting said solar cell module (1) in a circuit of multiple solar cell modules, and
a second contact (33) for connecting said solar cell module (1) in a circuit of multiple solar cell modules,
wherein the first solar cell of said at least two solar cells (8) is connected with said first contact (32) by said second electrically conductive area (30) and the last solar cell of said at least two solar cells (8) is connected with said second contact (33) by said third electrically conductive area (31).

3. A solar cell module (1) according to claim 1, further comprising
an inverter (40) having a first DC inverter contact (43) and a second DC inverter contact (44) and two AC inverter contacts (45,46) for assembling the solar cell module (1) in a circuit of multiple solar cell modules,
a fourth electrically conductive area (41) on the back surface (4) not in contact with said first electrically conductive area (10), and
a fifth electrically conductive area (42) on the back surface (4) not in contact with said first and fourth electrically conductive area (10, 41),
wherein said first DC inverter contact (43) is electrically connected with the first of said at least two solar cells (8) and by said fourth electrically conductive area (41) and said second DC inverter contact (44) is electrically connected with the last of said at least two solar cells (8) by said fifth electrically conductive area (42).

4. A solar cell module (1) according to claim 1, further comprising
a second electrically conductive area (30) on the back surface (4) not in contact with said first electrically conductive area (10),
a third electrically conductive area (31) on the back surface (4) not in contact with said first and second electrically conductive areas (10, 30),
a fourth electrically conductive area (41) on the back surface (4) not in contact with said first, second and third conductive areas (10, 30, 31), and
a fifth electrically conductive area (42) on the back surface (4) not in contact with said first, second, third and fourth electrically conductive areas (10, 30, 31, 42),
wherein said second electrically conductive area (30) is electrically connected to the first of said at least two solar cells (8) and is configured to be soldered to a first contact (32),
wherein said third electrically conductive area (31) is electrically connected to the last of said at least two solar cells (8) and is configured to be soldered to a second contact (33),
wherein said fourth electrically conductive area (41) is electrically connected to the first of said at least two solar cells (8) and is configured to be soldered to a first DC inverter contact (43), and
wherein said fifth electrically conductive area (42) is electrically connected to the last of said at least two solar cells (8) and is configured to be soldered to a second DC inverter contact (44).

5. A solar cell module (1) according to any of the preceding claims, said solar cell module comprising
at least three rows (70) of at least two solar cells (8) assembled between said first and second inner surface (3,7) and
a sixth electrically conductive area (50) on the back surface (4),
wherein said sixth electrically conductive area (50) electrically connects at least two solar cells (8) at an end of said substrate panel opposite to the end where said first electrically conductive area (10) is electrically connecting two solar cells.

6. A solar cell module (1) according to any of the preceding claims, wherein said first, second, third, fourth, fifth and sixth electrically conductive areas (10, 30, 31, 41, 42, 50) comprise a metal.

7. A solar cell module (1) according to any of the preceding claims, wherein said first, second, third, fourth, fifth and sixth electrically conductive areas (10, 30, 31, 41, 42, 50) comprise silver.

8. A solar cell module (1) according to any of the preceding claims, further comprising a polyurethane (PU) frame (60),
wherein said frame (60) covers at least one of said electrically conductive areas (10,30,31,41,42, 50).

9. A solar cell module (1) according to any of the preceding claims, comprising further electrically conductive areas on the back surface (4), wherein said further electrically conductive areas are configured to solder electronic components to the further electrically conductive areas.

10. A solar cell module (1) according to claim 8 or to claim 9 when dependent on claim 8, further comprising electronic components, wherein said electric components are embedded in said PU frame (60).

11. A solar cell module (1) according to claim 10, wherein said electronic components are positioned behind said second inner surface (7) such that heat generated by said electronic components is transferred through said cover panel (5).

12. A solar cell module (1) according to claims 10 or 11, wherein said electronic components are bypass diodes (20).

13. A solar cell module (1) according to claims 10 to 12, further comprising means for accelerating heat transfer from said electronic components to said cover panel (5).

14. A solar cell module (1) according to any of the preceding claims, wherein said substrate panel (2) comprises a first (84), a second (85), a third (86) and a fourth (87) substrate side surface,
wherein said cover panel comprise a first (80), a second (81), a third (82) and a fourth (83) cover side surface,
wherein said substrate panel (2) is in at least one direction, width or height, shorter than the cover panel (5), and
wherein at least one of said substrate side surfaces of said substrate panel (2) is at a distance from said corresponding side surface of said cover panel (5).

15. A solar cell module (1), comprising
a substrate panel (2) comprising a first inner surface (3), a back surface (4) and first (84), second (85), third (86) and fourth (87) substrate side surfaces,
a cover panel (5) comprising a front surface (6) and a second inner surface (7), and first (80), second (81), third (82) and fourth (83) cover side surfaces, and
at least two solar cells (8) assembled between said first (3) and second inner surface (7),
**characterized in that**,
said substrate panel (2) is in at least one direction, width or height, shorter than the cover panel (5), and at least one of said substrate side surfaces of said substrate panel (2) is at a distance from said corresponding side surface of said cover panel (5).
